# EUROPEAN PATENT SPECIFICATION

(11) **EP 3 978 209 B1**
(45) Date of publication and mention of the grant of the patent: **27.09.2023**
(21) Application number: 21199635.0
(22) Date of filing: 28.09.2021
(51) Int. Cl.: B25J 19/00

(54) **GENERATIVE DESIGN TECHNIQUES FOR SOFT ROBOT MANIPULATORS**
TECHNIKEN ZUM GENERATIVEN DESIGN FÜR WEICHROBOTERMANIPULATOREN
TECHNIQUES DE CONCEPTION GÉNÉRATIVE POUR MANIPULATEURS DE ROBOT SOUPLES

(30) Priority: 05.10.2020 US 202063087840 P; 10.06.2021 US 202117344710
(43) Date of publication of application: 06.04.2022
(73) Proprietor: Autodesk, Inc., San Francisco, CA 94105 (US)
(72) Inventor: CHEONG, Hyunmin, San Rafael, 94903 (US); EBRAHIMI, Mehran, San Rafael (US)
(74) Representative: Kilburn & Strode LLP

(56) References cited:
- LASITHA WIJAYARATHNE ET AL: "Design-Informed Kinematic Control for Improved Dexterous Teleoperation of a Bilateral Manipulator System", ARXIV.ORG, CORNELL UNIVERSITY LIBRARY, 201 OLIN LIBRARY CORNELL UNIVERSITY ITHACA, NY 14853, 2 May 2020 (2020-05-02), XP081657211,
- HA SEHOON ET AL: "Computational co-optimization of design parameters and motion trajectories for robotic systems", INTERNATIONAL JOURNAL OF ROBOTICS RESEARCH., vol. 37, no. 13-14, 5 December 2018 (2018-12-05), pages 1521-1536, XP055894731, US ISSN: 0278-3649, DOI: 10.1177/0278364918771172 Retrieved from the Internet: URL:http://journals.sagepub.com/doi/full-x ml/10.1177/0278364918771172>

## Description

### BACKGROUND

### Cross-Reference to Related Applications

This application claims priority benefit of the United States Provisional Patent Application titled, "GENERATIVE DESIGN OF SOFT ROBOTIC ARMS," filed on October 5, 2020 and having Serial No. 63/087,840.

### Field of the Various Embodiments

The various embodiments relate generally to computer science and robotics, and, more specifically, to generative design techniques for soft robot manipulators.

### Description of the Related Art

Robots are oftentimes employed for tasks that require high repetition, can be dangerous to humans, and/or require high-precision. For example, robots are frequently implemented in manufacturing applications and environments that are hazardous to humans. As a general matter, robots are machines that are automated or semi-automated, programmable, and capable of complex planar or three-dimensional movements. Many conventional robots are implemented with rigid components (e.g., actuators, manipulators, and end effectors), but, for improved dexterity, flexibility, and adaptability, continuum robots (also referred to as "soft robots") have been developed.

Continuum robots typically include one or more joints that can bend continuously along a finite length. The design and functionality of these continuously flexible joints are inspired by serpentine animal appendages, such as elephant trunks and octopus tentacles. The additional flexibility afforded by the continuously flexible joints makes continuum robots ideal for working in cluttered environments and enables continuum robots to be more adaptable in interacting with their surroundings relative to more traditional rigid robots. For example, in operation, a continuum robot can reach around nearby objects or otherwise modify its configuration to avoid collisions.

One drawback of continuum robots is that developing suitable robot designs for particular operating scenarios is quite difficult and can take weeks to complete due the multitude of design parameters, performance requirements, and constraints associated with any given operating scenario. For example, for each joint of a continuum robot, a length and minimum required bending radius has to be determined that allows the end effector of the continuum robot to perform a targeted trajectory and/or reach certain regions of a targeted workspace. In addition, one or more performance requirements of the continuum robot may be considered, such as dexterity (e.g., whether the continuum robot can reach a target with multiple orientations), manipulability (e.g., ability to reach multiple points as a function of robot configuration), and/or power/torque required to operate the continuum robot. Further, a continuum robot design is typically optimized with respect to one or more objective criteria (such as the length, weight, and/or number of joints of the continuum robot) in order to finalize the design, a procedure that involves multiple iterations of the overall design process.

Another drawback of continuum robots is that conventional design processes, even extensive ones, oftentimes fail to produce optimal design solutions for given operating scenarios. For example, a final robot design generated via a conventional design process may meet certain minimum performance objectives, such as not exceeding a maximum allowable robot arm length or weight; however, because a typical robot design is generated via a relatively small number of design process iterations, the overarching design space usually cannot be explored with a reasonable level of granularity. As a result, many better-performing design solutions may not be considered when designing continuum robots using conventional design approaches.

As the foregoing illustrates, what is needed in the art are more effective techniques for generating designs for continuum robots.

"Design-informed kinematic control for improved dexterous teleoperation of a bilateral manipulator system" by Lasitha Wijayarathne et al dated 2 May 2020 describes the possibility of improving bilateral robot manipulation task performance through optimizing the robot morphology and configuration of the system through motion. To optimize the design for different scenarios, a set of tasks is selected that represent the variability in small scale manipulation (e.g. pick and place, tasks involving positioning and orientation) and track the motion to obtain a reproducible trajectory. Kinematic data is captured through an electromagnetic (EM) tracker system while a human subject performs the tasks. Then, the data is pre-processed and used to optimize the morphology of each symmetric robot arm of the bilateral system. Once optimized, a kinematic control scheme is used to generate a motion with dexterous configurations. The dexterity is evaluated along the trajectories with standard dexterity metrics.

### SUMMARY

A computer-implemented method for generating a design for a continuum robot includes: generating a first plurality of candidate designs for the continuum robot, wherein each candidate design included in the first plurality of candidate designs is based on a first set of values for a set of design parameters; determining a first performance value for each candidate design included in the first plurality of candidate designs; based at least in part on the first performance values, selecting a subset of candidate designs from the first plurality of candidate designs; and based on the subset of candidate designs, generating a second plurality of candidate designs for the continuum robot, wherein each candidate design included in the second plurality of candidate designs is based on a second set of values for the set of design parameters.

At least one technical advantage of the disclosed techniques relative to the prior art is that, with the disclosed techniques, one or more designs for a continuum robot can be automatically generated without extensive kinematic analyses being performed by a robotics expert. Another advantage is that a final design generated using the disclosed techniques is based on a wide range of values for the different design parameters associated with a given operating scenario. Accordingly, the disclosed techniques enable the overall design space to be explored more comprehensively relative to conventional design processes. Consequently, the disclosed techniques substantially increase the likelihood of generating better-performing design solutions for continuum robots relative to conventional design processes. These technical advantages provide one or more technological advancements over prior art approaches.

### BRIEF DESCRIPTION OF THE DRAWINGS

So that the manner in which the above recited features of the various embodiments can be understood in detail, a more particular description of the inventive concepts, briefly summarized above, may be had by reference to various embodiments, some of which are illustrated in the appended drawings. It is to be noted, however, that the appended drawings illustrate only typical embodiments of the inventive concepts and are therefore not to be considered limiting of scope in any way, and that there are other equally effective embodiments.
Figure 1 illustrates a generative design system configured to implement one or more aspects of the various embodiments.
Figure 2 is a conceptual illustration of a continuum robot, according to various embodiments.
Figure 3 is a more detailed illustration of the continuum robot of Figure 2, according to various embodiments.
Figure 4 is another more detailed illustration of the continuum robot of Figure 2, according to various embodiments.
Figure 5 is yet another more detailed illustration of the continuum robot of Figure 2, according to various embodiments.
Figure 6 is a plan view of a continuum robot and an associated workspace, according to various embodiments.
Figure 7 schematically illustrates a reachability factor for a continuum robot with respect to the workspace of Figure 6, according to various embodiments.
Figure 8 schematically illustrates a continuum robot and an end effector trajectory associated therewith, according to various embodiments.
Figure 9 sets forth a flowchart of method steps for generating one or more designs for a continuum robot, according to various embodiments.
Figure 10 is a block diagram of a computing device configured to implement one or more aspects of the various embodiments.

For clarity, identical reference numbers have been used, where applicable, to designate identical elements that are common between figures. It is contemplated that features of one embodiment may be incorporated in other embodiments without further recitation.

### DETAILED DESCRIPTION

In the following description, numerous specific details are set forth to provide a more thorough understanding of the various embodiments. However, it will be apparent to one of skill in the art that the inventive concepts may be practiced without one or more of these specific details.

### Design Inputs for Continuum Robot Design

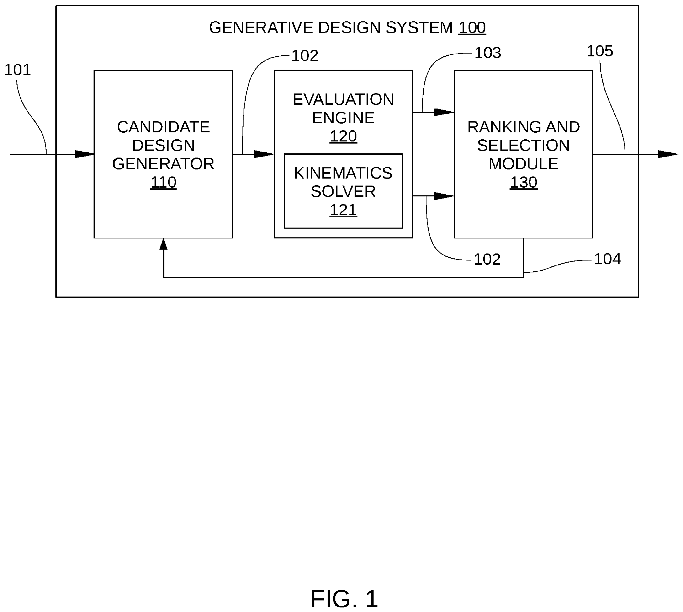

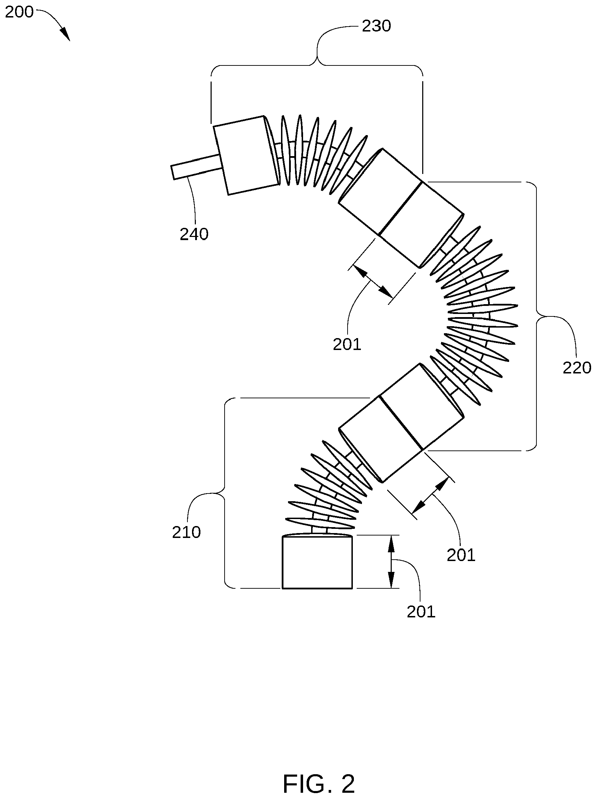

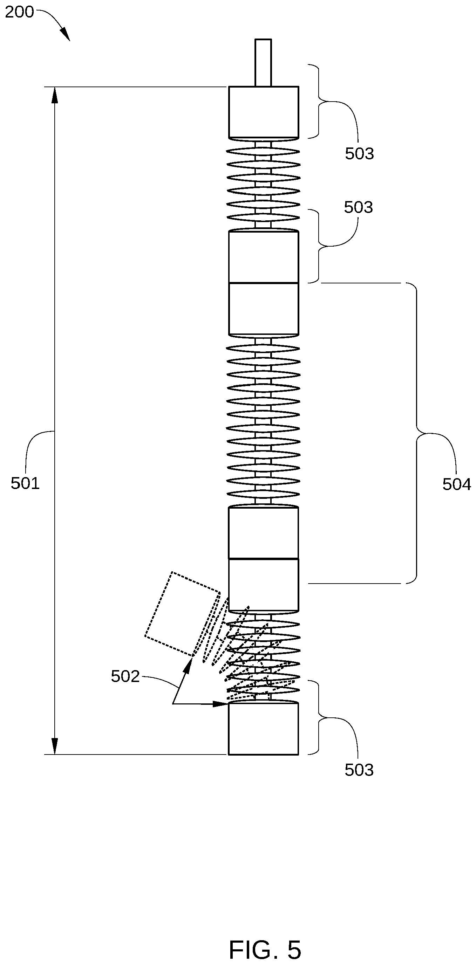

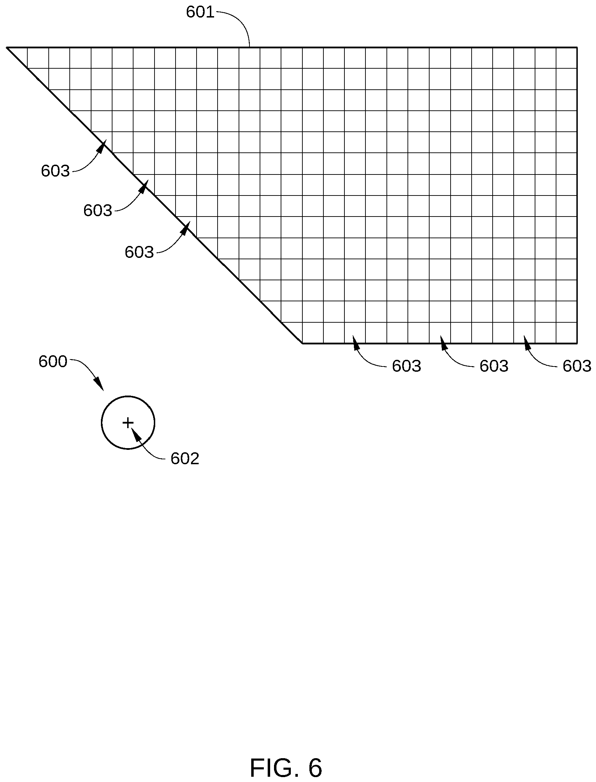

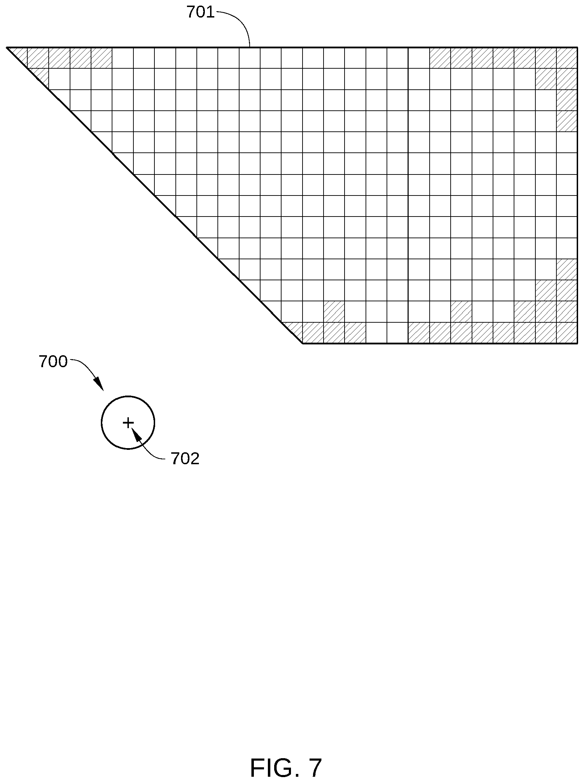

Figure 1 illustrates a generative design system 100 configured to implement one or more aspects of the various embodiments. Generative design system 100 is configured to generate one or more continuum robot output designs 105 for a particular set of design inputs 101. In some embodiments, design inputs 101 are provided to generative design system 100 via one or more user inputs. For a particular design problem, design inputs 101 include a plurality of design parameters and one (or usually multiple) objective criteria for improving each iteration of candidate designs for the continuum robot. Further, in some embodiments, design inputs 101 include one or more design constraints and/or one or more performance criteria for determining performance of each potential continuum robot design. Certain example design parameters associated with generating candidate designs are described below in conjunction with Figures 2 - 5, certain example design constraints associated with generating candidate designs are described below in conjunction with Figure 6, certain objective criteria associated with generating candidate designs are described below in conjunction with Figure 5, and certain performance criteria associated with evaluating candidate designs are described below in conjunction with Figures 7-8.

Each design parameter included in design inputs 101 can be varied to generate a different potential design. In the case of a continuum robot design, the design parameters included in design inputs 101 indicate specific features of a continuum robot that can be varied to produce a different instance of a continuum robot design. For example, in some embodiments such design parameters may include the total number of continuum joints included in the continuum robot design, a minimum available bending radius for each continuum joint included in the continuum robot design, a straightened length for each continuum joint included in the candidate design, etc.

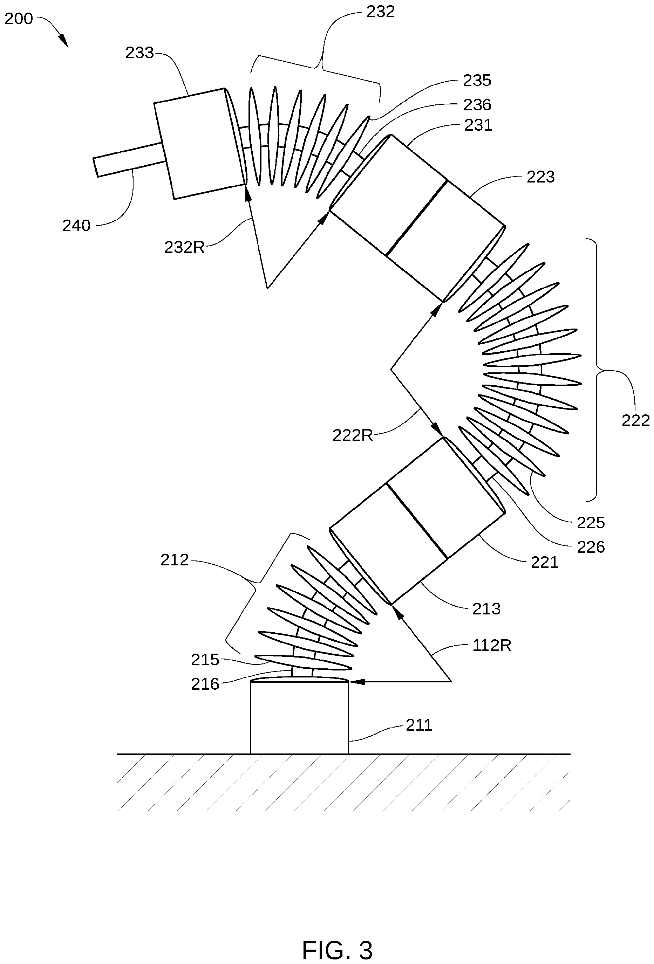

Figure 2 is a conceptual illustration of a continuum robot 200, according to various embodiments, and Figure 3 is a more detailed illustration of continuum robot 200, according to various embodiments. Continuum robot 200 can be a design for a robot, machine, or device configured to perform one or more repetitive, dangerous, and/or high-precision tasks. Such tasks may be related to manufacturing, hazardous environments, exploration, inspection, and/or the like, and may be performed in addition to or in lieu of tasks and/or actions performed by one or more humans. In some embodiments, continuum robot 200 is a robot, machine, or device that is configured to operate with certain user input, such as pre-programmed motions and/or operations. Alternatively or additionally, in some embodiments, such a robot, machine, or device is configured to operate autonomously, for example in response to sensor input received from sensors (not shown).

Continuum robot 200 includes one or more continuum joints, each of which is a "soft" or flexible joint that is configured to change shape during operation. Therefore, each continuum joint generally does not remain rigid and have the same shape at all times during operation. Instead, each continuum joint included in continuum robot 200 is configured to deform to a particular target bending radius in a particular target direction to cause a targeted motion and orientation of a rigid top portion of the continuum joint to occur relative to a rigid base portion of the continuum joint.

In the embodiment illustrated in Figures 2 and 3, continuum robot 200 includes three continuum joints 210, 220, and 230, coupled in series as shown, and an end effector 240. Continuum joint 210 includes a base portion 211, a spine 212, and a top portion 213, continuum joint 220 includes a base portion 221, a spine 222, and a top portion 223, and continuum joint 230 includes a base portion 231, a spine 232, and a top portion 233. Further, in the embodiment illustrated in Figures 2 and 3, continuum joints 210, 220, and 230, each include rigid portions and a selectively deformable portion. Specifically, base portion 211, base portion 221, base portion 231, top portion 213, top portion 223, and top portion 233 are straight and rigid portions, and spine 212, spine 222, and spine 232 are flexible and selectively deformable portions.

In some embodiments, spine 212 is configured to bend to a target bending radius 212R, and thereby modify the position and orientation of top portion 213 relative to base portion 211. In some embodiments, spine 212 is configured so that target bending radius 212R can vary from a minimum bending radius to a maximum bending radius of infinity, i.e., where spine 212 is configured as a straight segment. Generally, a value of the minimum bending radius in a particular configuration of continuum robot 200 is based on details of the mechanical design of spine 212, such as material properties of the various components of spine 212 and/or the morphology and physical dimensions of the various components of spine 212. Similarly, in some embodiments, spine 222 is configured to bend to a target bending radius 222R, and thereby modify the position and orientation of top portion 223 relative to base portion 221, and spine 232 is configured to bend to a target bending radius 232R, and thereby modify the position and orientation of top portion 233 relative to base portion 231. By selective bending of spine 212, spine 222, and/or spine 232, end effector 240 can be positioned at a target position in a three-dimensional space based on continuum robot 200 and oriented with a target orientation in the three-dimensional space. As a result, the continuum robot can access some or all portions of a workspace (not shown) that is located in the three-dimensional space proximate the continuum robot.

In some embodiments, the selective bending of spine 212, spine 222, and/or spine 232, is enabled, for example, via pneumatic actuation of pneumatic cells arranged along a core element. Thus, in the embodiment illustrated in Figures 2 and 3, selective bending of spine 212 is enabled via pneumatic actuation of pneumatic cells 215 arranged along a core element 216 of spine 212, selective bending of spine 222 is enabled via pneumatic actuation of pneumatic cells 225 arranged along a core element 226 of spine 222, and selective bending of spine 232 is enabled via pneumatic actuation of pneumatic cells 235 arranged along a core element 236 of spine 232. In such embodiments, selective inflation and deflation of certain cells along the core element cause the core element to bend with a specific target bending radius. In other embodiments, any other technically feasible actuators included in spine 212, spine 222, and spine 232 can be employed to enable similar bending of spine 212, spine 222, and spine 232.

In the embodiment illustrated in Figures 2 and 3, target bending radius 212R, target bending radius 222R, and target bending radius 232R are each shown residing in the same plane. In practice, the selective bending of spine 212, spine 222, and/or spine 232 is not restricted to two-dimensions, and may occur in three-dimensional space.

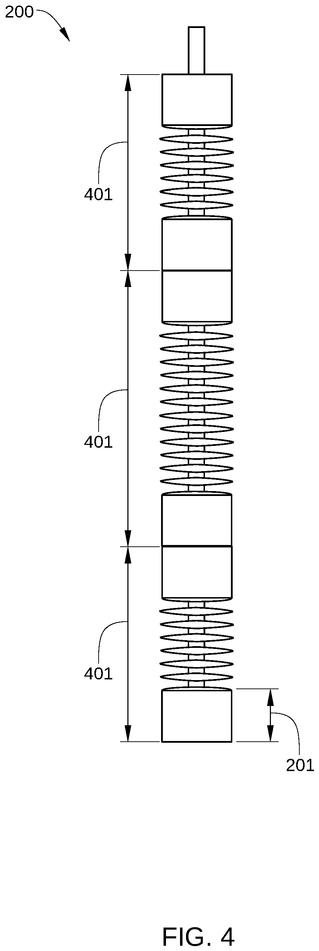

In some embodiments, design parameters associated with continuum robot 200 include one or more of a number of continuum joints included in the candidate design and a length 201 for the rigid portion(s) of each continuum joint included in the candidate design. In the embodiment illustrated in Figures 2 and 3, the number of continuum joints included in continuum robot 200 is three, but other candidate designs can have more or fewer continuum joints. Further, in the embodiment illustrated in Figures 2 and 3, length 201 for base portion 211, base portion 221, base portion 231, top portion 213, top portion 223, and top portion 233 is the same value. In other embodiments, length 201 can vary in a particular continuum robot 200 for each rigid portion included therein. Additionally or alternatively, in some embodiments, design parameters associated with continuum robot 200 include a straightened length for each continuum joint included in the candidate design. Examples of straightened lengths for continuum joints are shown in Figure 4. Figure 4 is another more detailed illustration of continuum robot, according to various embodiments.

As noted above, for a particular design problem, design inputs 101 of Figure 1 may include one or more design constraints. In general, such design constraints are imposed on one or more aspects of the candidate robot design that are generated by generative design system 100 for the particular design problem. For example, in some embodiments, one or more design constraints included in design inputs 101 are dimensional limits for certain features of candidate robot designs. Examples of such dimensional limits are shown in Figure 5.

Figure 5 is another illustration of continuum robot 200, according to various embodiments. In the embodiment illustrated in Figure 5, the dimensional limits shown include a maximum total arm length 501 of the candidate continuum robot design, a minimum bending radius 502 for some or all continuum joints included in the candidate continuum robot design, a maximum length 503 for some or all rigid portions of each continuum joint included in the candidate continuum robot design, and a maximum straightened length 504 for each continuum joint included in the candidate continuum robot design. Besides the above-described dimensional limits, other design constraints that may be included in design inputs 101 are a maximum number of continuum joints included in a candidate continuum robot design, a minimum number of continuum joints included in the candidate continuum robot design, a required number of continuum joints included in the candidate continuum robot design, a maximum allowable weight of the candidate continuum robot design, and/or the like.

In some embodiments, one or more design constraints included in design inputs 101 are associated with a workspace that is reachable by a candidate continuum robot design. An example of such design constraint is shown in Figure 6. Figure 6 is a plan view of a continuum robot 600 based on continuum robot 200 and an associated workspace 601, according to various embodiments. In the embodiment illustrated in Figure 6, continuum robot 600 is positioned proximate workspace 601 at a base location 602, according to information included in design inputs 101. Workspace 601 represents a three-dimensional region that is to be accessed by continuum robot 600 and is discretized into a plurality of locations 603 (also referred to as voxels). In Figure 6, workspace 601 is depicted as a two-dimensional region for clarity, but in practice workspace 601 is typically a three-dimensional volume of locations 603.

The ability for continuum robot 600 to access some or all of workspace 601 is generally a function of the configuration of continuum robot 600, including the size, number, and minimum bending radius of each continuum joint of continuum robot 600. The ability for continuum robot 600 to access some or all of workspace 601 is also a function of the shape of workspace 601 and relative positioning of workspace 601 and base location 602. Thus, in some embodiments, design constraints associated with workspace 601 include the shape of workspace 601 and the relative positioning of workspace 601 and base location 602.

As noted above, for a particular design problem, design inputs 101 of Figure 1 may include one or more objective criteria for improving each iteration of candidate designs generated by generative design system 100. In some embodiments, generative design system 100 uses such objective criteria in a global optimization process when selecting a new iteration of candidate designs. Namely, an objection function of the global optimization process is based on the objective criteria. Thus, in such embodiments, design parameter values for a new iteration of candidate designs are generated based on the objective function and on design parameter values for one or more previous iterations of candidate designs generated by generative design system 100.

In some embodiments, one or more objective criteria included in design inputs 101 include one or more of a maximum total arm length of a candidate design, a torque factor for the candidate design, a weight of the candidate design, and a number of continuum joints included in the candidate design. In such embodiments, the reduction of some or all of the above objective criteria generally results in candidate designs that not only meet the specified design goals for a particular operating scenario, but are also higher quality designs, i.e., smaller, subject to lower torque, lighter, and/or having fewer continuum joints. Consequently, performing minimization of an objective function based on such objective criteria enables selection of design parameter values for a new iteration of candidate designs that are higher quality than previous iterations of candidate designs.

An example of a maximum total arm length 501 of a candidate continuum robot design is illustrated by maximum total arm length 501 in Figure 5. In some embodiments, a torque factor for a candidate design is a measure of torque when an end effector (or some other component of a candidate design) is in a specified configuration, such as a configuration that provides maximum reach of the candidate design, a configuration that enables a farthest location in a workspace to be accessed, etc. In such embodiments, the torque factor may be a summation of torques at the base of each continuum joint of the candidate design, a torque at the base of a particular continuum joint of the candidate design, or a torque at the base of joint of the candidate design.

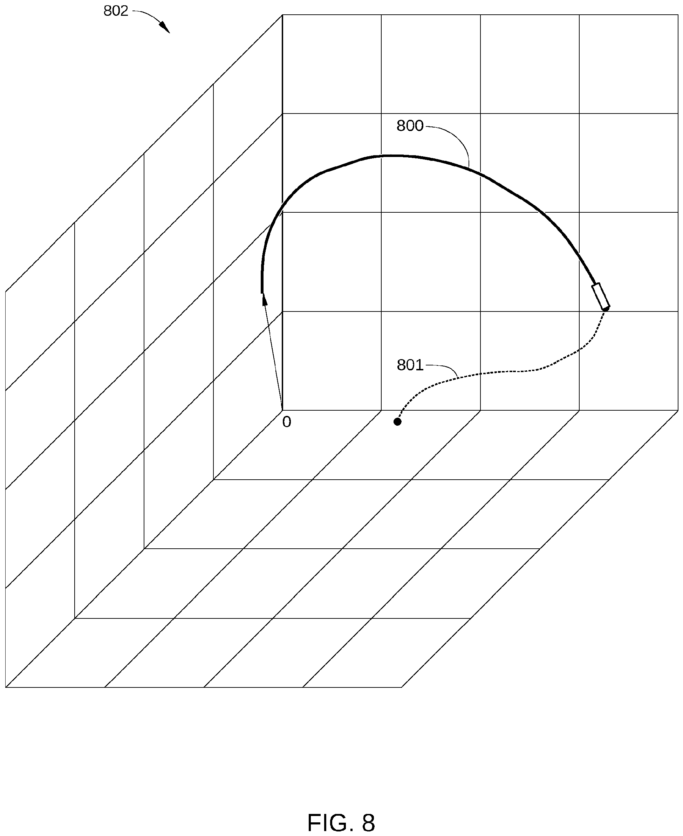

As noted above, for a particular design problem, design inputs 101 of Figure 1 may include one or more performance criteria for determining the performance of a candidate continuum robot design. In general, such performance criteria enable comparison of the relative performance of different candidate designs generated by generative design system 100. For example, in some embodiments, examples of performance criteria included in design inputs 101 are a reachability factor for candidate designs generated by generative design system 100 and a trajectory factor for candidate designs generated by generative design system 100. Embodiments of a reachability factor are described below in conjunction with Figure 7, and embodiments of a trajectory factor are described below in conjunction with Figure 8.

Figure 7 schematically illustrates a reachability factor for a particular continuum robot 700 with respect to a workspace 701, according to various embodiments. In Figure 7, continuum robot 700 and workspace 701 are shown in a plan view. Continuum robot 700 is based on a particular continuum robot design, such as continuum robot 200 of Figure 2, and is positioned proximate workspace 701 at a base location 702, according to information included in design inputs 101. Workspace 701 represents a three-dimensional region that is to be accessed by continuum robot 700.

In some embodiments, a reachability factor for continuum robot 700 is based on how much of workspace 701 can be reached or otherwise accessed by continuum robot 700. In such embodiments, the reachability factor can be a percentage value indicating how much of workspace 701 continuum robot 700 can reach, for example with an end effector. Thus, when continuum robot 700 cannot reach all locations within workspace 701, continuum robot 700 has a reachability factor that is less than 1.0. In the embodiment illustrated in Figure 7, locations within workspace 701 that cannot be reached by continuum robot 700 are indicated with cross hatching.

Figure 8 schematically illustrates a continuum robot 800 and an end effector trajectory 801 associated with continuum robot 200, according to various embodiments. In Figure 8, continuum robot 800 and end effector trajectory 801 are shown in a three-dimensional space 802. Continuum robot 800 is based on continuum robot 200. End effector trajectory 801 can be a specified trajectory associated with a particular operating scenario for continuum robot 800, such as a weld line, a painting path, or any other trajectory to be followed by an end effector or other portion of continuum robot 800. In some embodiments, a velocity and/or acceleration profile is associated with end effector trajectory 801.

In some embodiments, a trajectory factor for continuum robot 800 is based on how closely continuum robot 800 can follow end effector trajectory 801 and/or any associated velocity/acceleration profile. In other embodiments, a trajectory factor for continuum robot 800 is a binary factor indicating whether continuum robot 800 can follow end effector trajectory 801.

### Exemplary Implementation

Returning to Figure 1, generative design system 100 includes a candidate design generator 110, an evaluation engine 120, and a ranking and selection module 130. In the embodiment illustrated in Figure 1, candidate design generator 110, evaluation engine 120, and ranking and selection module 130 are described as separate components of generative design system 100. In other embodiments, the functionality of candidate design generator 110, evaluation engine 120, and/or ranking and selection module 130 can be combined into a single software application or other otherwise configured. According to various embodiments, generative design system 100 generates different iterations of candidate designs 102 for a continuum robot that are each more likely to have an improved reachability factor, trajectory factor, and/or other performance factor than the candidate designs of previous iterations.

Candidate design generator 110 is configured to generate one or more candidate designs 102 of a continuum robot for each iteration of continuum robot design and evaluation performed by generative design system 100. Generally, candidate design generator 110 generates candidate designs 102 based on design inputs 101. Specifically, for each candidate design 102, candidate design generator 110 determines a different set of values for the design parameters included in design inputs 101.

In some embodiments, candidate design generator 110 generates candidate designs 102 for one iteration based on values for the design parameters of the candidate designs of a previous iteration. In such embodiments, candidate design generator 110 generates a first set of values for the design parameters of candidate designs 102 based on a second set of values, i.e., the values for the design parameters of the candidate designs of a selected subset 104 of candidate designs that have been selected by ranking and selection module 130. In some embodiments, the values included in the first set of values are selected by minimizing an objective function that is based on objective criteria included in design inputs 101.

In some embodiments, the values included in the first set of values are selected from probability distributions generated based on the second set of values. For example, for a particular design parameter (e.g., length of a particular continuum joint), a probability distribution is generated from the values for that particular design parameter in the selected subset 104 of candidate designs. In such embodiments, the probability distribution may include an average value for that particular design parameter and a standard deviation of the values for that particular design parameter. Thus, candidate design generator 110 selects values for the particular design parameter in a new iteration of candidate designs 102 that are close in value to the average value in the probability distribution. In other embodiments, candidate design generator 110 bases the values included in the first set of values on the second set of values using any other suitable probability model of the values included in the first set of values.

Evaluation engine 120 is configured to generate one or more performance values 103 for each candidate design 102 generated by candidate design generator 110. Generally, evaluation engine 120 generates the performance values 103 based on one or more performance criteria included in design inputs 101, such as a reachability factor, a trajectory factor, and/or any other suitable performance criterion.

In some embodiments, evaluation engine 120 includes a kinematics solver 121 that is configured to analyze the kinematics of candidate designs 102. In such embodiments, based on the values of the design parameters for a particular candidate design 102, kinematics solver 121 determines which locations within a workspace are reachable by the particular candidate design 102. In some embodiments, kinematics solver 121 determines such locations via an inverse kinematics process or calculation for the particular candidate design 102. Inverse kinematics solvers are well-known in the art, and any suitable kinematics solver algorithm can be employed by kinematics solver 121.

Alternatively, in some embodiments, kinematics solver 121 determines the locations that are reachable by the particular candidate design 102 via a statistical, forward-kinematics approach. In such embodiments, a random sample of a large number of configurations of the particular candidate design 102 are selected, and the location reached by each random sample is determined via a simple forward kinematics calculation. For example, for each continuum joint included in the particular candidate design 102, a range of different deflection angles is selected. Each possible permutation of the different possible selected deflection angles for the continuum joints is then employed as one of the random samples. It is noted that a single forward kinematics calculation for one random sample requires much fewer computational resources than a single inverse kinematics calculation for one particular location. As a result, a very large number (e.g., a million or more) of such randomly sampled "reachable" locations within a given workspace can be calculated more quickly than performing an inverse kinematics calculation for each location within the given workspace.

Alternatively, in some embodiments, kinematics solver 121 determines the locations that are reachable by the particular candidate design 102 via a hybrid approach, in which a combination of the above-described statistical approach and an inverse-kinematics approach is employed. Therefore, in such embodiments, the hybrid approach is a novel combination of conventional methods for determining reachability for a continuum robot. In such embodiments, the locations reached by randomly sampled configurations of the particular candidate design 102 are determined via forward kinematics calculations. Further, when the portion of the locations in the workspace that are confirmed to be reachable via such random sampling exceeds a threshold value, for example 95%, the remaining locations in the workspace that have not yet been confirmed to be reachable are analyzed via an inverse kinematics process. Thus, when a candidate design 102 appears likely to reach most or all locations in a workspace, the reachability of the small number of remaining locations is directly determined via the inverse kinematics process.

In some embodiments, kinematics solver 121 determines whether a particular end effector trajectory included in design inputs 101 can be implemented. For example, in some embodiments, kinematics solver 121 determines whether an end effector trajectory can be performed by the candidate design 102 without any singularities. Additionally or alternatively, in some embodiments, kinematics solver 121 determines whether the candidate design 102 can follow an end effector trajectory 801 and/or implement a velocity or acceleration profile associated with end effector trajectory 801.

Ranking and selection module 130 is configured to determine the best-performing candidate designs 102 based on one or more performance values 103. Ranking and selection module 130 is further configured to generate selected subset 104 of candidate designs, where selected subset 104 of candidate designs includes the best-performing candidate designs 102 of the current iteration of candidate designs generated by generative design system 100. For example, in some embodiments, the best-performing half or third of candidate designs 102 are included in selected subset 104 of candidate designs. In some embodiments, ranking and selection module 130 selects the best-performing candidate designs 102 based on a single performance value 103. In other embodiments, ranking and selection module 130 selects the best-performing candidate designs 102 based on a combination of multiple performance values 103, for example via a weighted sum of the multiple performance values 103.

### Generative Design of Continuum Robot

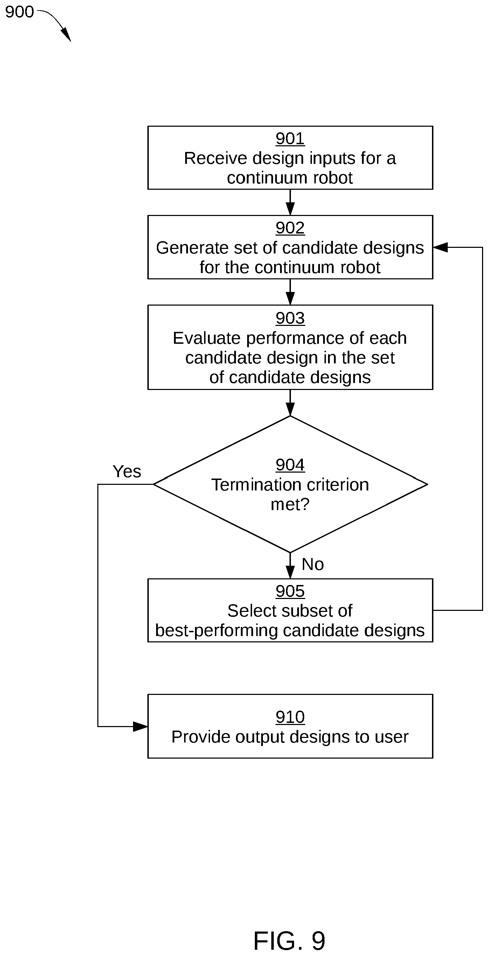

Figure 9 sets forth a flowchart of method steps for generating one or more designs for a continuum robot, according to various embodiments. Although the method steps are described in conjunction with the systems of Figures 1 - 8, persons skilled in the art will understand that any system configured to perform the method steps, in any order, is within the scope of the embodiments.

As shown, a computer-implemented method 900 begins at step 901, where generative design system 100 receives a particular set of design inputs 101 for a continuum robot. As noted, design inputs 101 may include a plurality of design parameters, one or more objective criteria, one or more design constraints, and/or one or more performance criteria.

In step 902, generative design system 100 generates a set of candidate designs 102 for the continuum robot, for example via candidate design generator 110. In an initial iteration of steps 902 - 905, candidate design generator 110 generates the set of candidate designs 102 based on design inputs 101, for example using random values for each design parameter included in design inputs 101. In subsequent iterations of step 902 - 905, candidate design generator 110 may generate the set of candidate designs 102 based on the values for the design parameters of the candidate designs of a selected subset 104 of candidate designs. Additionally or alternatively, in subsequent iterations of step 902 - 905, candidate design generator 110 may generate the set of candidate designs 102 based on the values determined by minimizing an objective function that is based on objective criteria included in design inputs 101.

In step 903, generative design system 100 evaluates the performance of each candidate design 102, for example, via evaluation engine 120. In some embodiments, evaluation engine determines one or more performance values 103 for each candidate design 102. In some embodiments, to determine a performance value 103 associated with reachability, a hybrid approach as described herein is employed by kinematics solver 121 to determine locations that are reachable by a particular candidate design 102.

In step 904, generative design system 100 determines whether a termination criterion has been met. If yes, computer-implemented method 900 proceeds to step 910 and terminates; if no, computer-implemented method 900 proceeds to step 905. In some embodiments, the termination criterion can be a threshold value of the performance values 103 for one or more candidate designs 102 or a threshold value for a change in such performance values 103 compared to a previous value of performance values 103. In some embodiments, the termination criterion can be a number of iterations of steps 902 - 905 that have been performed for a particular continuum robot. In some embodiments, the termination criterion can be a threshold time interval during which iterations of steps 902 - 905 have been performed for a particular continuum robot.

In step 905, generative design system 100 selects a subset 104 of candidate designs, for example via ranking and selection module 130. In some embodiments, ranking and selection module 130 determines selected subset 104 of candidate designs based on the performance values 103 for each candidate design 102. Computer-implemented method 900 then returns to step 902, in which generative design system 100 generates a new set of candidate designs 102 for the continuum robot, for example via candidate design generator 110. Generally, candidate design generator 110 generates the new set of candidate designs based on selected subset 104.

In step 910, generative design system 100 terminates computer-implemented method 900. In some embodiments, generative design system 100 displays, stores, or otherwise provides continuum robot output designs 105 to a user in step 910.

### Exemplary Computing Device

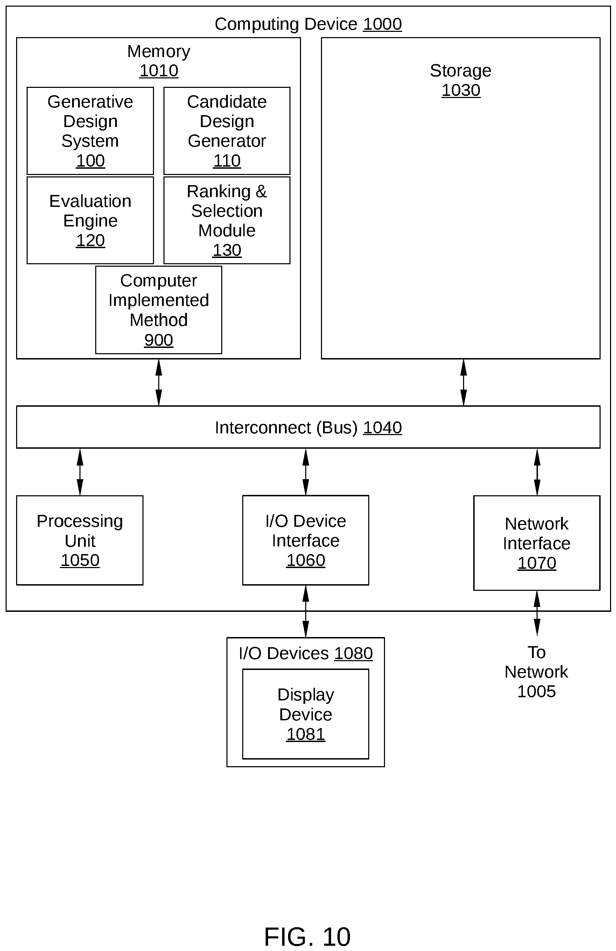

Figure 10 is a block diagram of a computing device 1000 configured to implement one or more aspects of the various embodiments. Thus, computing device 1000 can be a computing device associated with implementing controller 150 and/or any other computing device associated with continuum robot 100. Computing device 1000 may be a desktop computer, a laptop computer, a tablet computer, or any other type of computing device configured to receive input, process data, generate control signals, and display images. Computing device 1000 is configured to run generative design system 100, candidate design generator 110, evaluation engine 120, ranking and selection module 130, computer-implemented method 900 and/or other suitable software applications, which can reside in a memory 1010. It is noted that the computing device described herein is illustrative and that any other technically feasible configurations fall within the scope of the present disclosure.

As shown, computing device 1000 includes, without limitation, an interconnect (bus) 1040 that connects a processing unit 1050, an input/output (I/O) device interface 1060 coupled to input/output (I/O) devices 1080, memory 1010, a storage 1030, and a network interface 1070. Processing unit 1050 may be any suitable processor implemented as a central processing unit (CPU), a graphics processing unit (GPU), an application-specific integrated circuit (ASIC), a field programmable gate array (FPGA), any other type of processing unit, or a combination of different processing units, such as a CPU configured to operate in conjunction with a GPU. In general, processing unit 1050 may be any technically feasible hardware unit capable of processing data and/or executing software applications, including generative design system 100, candidate design generator 110, evaluation engine 120, ranking and selection module 130, and/or computer-implemented method 900. Further, in the context of this disclosure, the computing elements shown in computing device 1000 may correspond to a physical computing system (e.g., a system in a data center) or may be a virtual computing instance executing within a computing cloud.

I/O devices 1080 may include devices capable of providing input, such as a keyboard, a mouse, a touch-sensitive screen, and so forth, as well as devices capable of providing output, such as a display device 1081. Additionally, I/O devices 1080 may include devices capable of both receiving input and providing output, such as a touchscreen, a universal serial bus (USB) port, and so forth. I/O devices 1080 may be configured to receive various types of input from an end-user of computing device 1000, and to also provide various types of output to the end-user of computing device 1000, such as one or more graphical user interfaces (GUI), displayed digital images, and/or digital videos. In some embodiments, one or more of I/O devices 1080 are configured to couple computing device 1000 to a network 1005.

Memory 1010 may include a random access memory (RAM) module, a flash memory unit, or any other type of memory unit or combination thereof. Processing unit 1050, I/O device interface 1060, and network interface 1070 are configured to read data from and write data to memory 1010. Memory 1010 includes various software programs that can be executed by processor 1050 and application data associated with said software programs, including generative design system 100, candidate design generator 110, evaluation engine 120, ranking and selection module 130, and/or computer-implemented method 900.

In sum, the various embodiments described herein provide techniques for the generating one or more designs for a continuum robot. In the embodiments, candidate designs are generated and, using a kinematics solver, performance of each candidate design is evaluated. A subsequent set of candidate designs is then generated based on the values of design parameters of the best-performing candidate designs.

At least one technical advantage of the disclosed techniques relative to the prior art is that, with the disclosed techniques, one or more designs for a continuum robot can be automatically generated without extensive kinematic analyses being performed by a robotics expert. Another advantage is that a final design generated using the disclosed techniques is based on a wide range of values for the different design parameters associated with a given operating scenario. Accordingly, the disclosed techniques enable the overall design space to be explored more comprehensively relative to conventional design processes. Consequently, the disclosed techniques substantially increase the likelihood of generating better-performing design solutions for continuum robots relative to conventional design processes. These technical advantages provide one or more technological advancements over prior art approaches.

Aspects of the present embodiments may be embodied as a system, method or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "module," a "system," or a "computer." In addition, any hardware and/or software technique, process, function, component, engine, module, or system described in the present disclosure may be implemented as a circuit or set of circuits. Furthermore, aspects of the present disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

Aspects of the present disclosure are described above with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus. The instructions, when executed via the processor of the computer or other programmable data processing apparatus, enable the implementation of the functions/acts specified in the flowchart and/or block diagram block or blocks. Such processors may be, without limitation, general purpose processors, special-purpose processors, application-specific processors, or field-programmable gate arrays.

The flowchart and block diagrams in the figures illustrate the architecture, functionality, and operation of possible implementations of systems, methods and computer program products according to various embodiments of the present disclosure. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

While the preceding is directed to embodiments of the present disclosure, other and further embodiments of the disclosure may be devised without departing from the basic scope thereof, and the scope thereof is determined by the claims that follow.

## Claims

1. A computer-implemented method for generating a design for a continuum robot (200), the method comprising:
generating (902) a first plurality of candidate designs (102) for the continuum robot, wherein each candidate design included in the first plurality of candidate designs is based on a first set of values (101) for a set of design parameters;
determining (903) a first performance value for each candidate design included in the first plurality of candidate designs;
based at least in part on the first performance values, selecting (905) a subset of candidate designs (104) from the first plurality of candidate designs; and
based on the subset of candidate designs, generating (902) a second plurality of candidate designs for the continuum robot, wherein each candidate design included in the second plurality of candidate designs is based on a second set of values for the set of design parameters.

2. The computer-implemented method of claim 1, wherein the set of design parameters includes at least one of a number of continuum joints (210, 220, 230) included in a candidate design, a minimum bending radius for each continuum joint included in the candidate design, a length for a rigid portion associated with each continuum joint included in the candidate design, or a straightened length for each continuum joint included in the candidate design.

3. The computer-implemented method of claim 1 or claim 2, wherein the first performance value is based on at least one of an objective criterion associated with the continuum robot (200), a performance criterion associated with the continuum robot, a region of a workspace that is reachable by the candidate design included in the first plurality of candidate designs, or a trajectory within the workspace that can be performed by the candidate design included in the first plurality of candidate designs.

4. The computer-implemented method of claim 3, wherein the objective criterion associated with the continuum robot (200) includes at least one of a total arm length, a torque factor, a total weight, or a number of continuum joints (210, 220, 230) included in the continuum robot.

5. The computer-implemented method of claim 3 or claim 4, wherein the performance criterion associated with the continuum robot (200) includes at least one of a reachability factor or a trajectory factor.

6. The computer-implemented method of claim 5, wherein determining the first performance value comprises performing a hybrid approach that includes determining reachability for a first portion of the region of the workspace via forward kinematics and reachability for a second portion of the region of the workspace via inverse kinematics.

7. The computer-implemented method of claim 6, wherein generating the first plurality of candidate designs comprises computing values for the first set of values that conform to the at least one design parameter constraint.

8. The computer-implemented method of claim 6 or claim 7, wherein the at least one design parameter constraint includes at least one of a maximum number of continuum joints (210, 220, 230) included in the continuum robot (200), a minimum number of continuum joints included in the continuum robot, a required number of continuum joints included in the continuum robot, a maximum total arm length of the continuum robot, a relative position between the continuum robot and a workspace, or a shape of the workspace.

9. The computer-implemented method of any of claims 1-8, wherein generating the first plurality of candidate designs comprises computing, for each candidate design included in the first plurality of candidate designs, the first set of values based on a global optimization process.

10. The computer-implemented method of claim 9, wherein the global optimization process includes an objective function that is based on a plurality of objective criteria associated with the continuum robot (200).

11. A computer readable medium storing instructions that, when executed by a processor, cause the processor to perform the method of any of claims 1-10.

12. A system, comprising:
a memory (1010) that stores instructions; and
a processor (1050) that is communicatively coupled to the memory and is configured to, when executing the instructions, perform the method of any of claims 1-10.

## Patentansprüche

1. Computerimplementiertes Verfahren zum Erzeugen eines Designs für einen Kontinuum-Roboter (200), wobei das Verfahren umfasst:
Erzeugen (902) einer ersten Mehrzahl von Kandidatendesigns (102) für den Kontinuum-Roboter, wobei jedes Kandidatendesign, das in der ersten Mehrzahl von Kandidatendesigns enthalten ist, auf einem ersten Satz von Werten (101) für einen Satz von Designparametern basiert;
Bestimmen (903) eines ersten Leistungswertes für jedes Kandidatendesign, das in der ersten Mehrzahl von Kandidatendesigns enthalten ist;
Auswählen (905) einer Untergruppe von Kandidatendesigns (104) aus der ersten Mehrzahl von Kandidatendesigns, zumindest teilweise basierend auf den ersten Leistungswerten; und
Basierend auf der Untergruppe von Kandidatendesigns, Erzeugen (902) einer zweiten Mehrzahl von Kandidatendesigns für den Kontinuum-Roboter, wobei jedes Kandidatendesign, das in der zweiten Mehrzahl von Kandidatendesigns enthalten ist, auf einem zweiten Satz von Werten für den Satz von Designparametern basiert.

2. Computerimplementiertes Verfahren nach Anspruch 1, wobei der Satz von Designparametern eine Anzahl von Kontinuum-Gelenken (210, 220, 230), die in einem Kandidatendesign enthalten sind und/oder einen minimalen Biegeradius für jedes Kontinuum-Gelenk, das in dem Kandidatendesign enthalten ist und/oder eine Länge für einen starren Abschnitt, der jedem Kontinuum-Gelenk zugeordnet ist, das in dem Kandidatendesign enthalten ist, und/oder eine begradigte Länge für jedes Kontinuum-Gelenk, das in dem Kandidatendesign enthalten ist, enthält.

3. Computerimplementiertes Verfahren nach Anspruch 1 oder Anspruch 2, wobei der erste Leistungswert auf einem Zielkriterium, das dem Kontinuum-Roboter (200) zugeordnet ist und/oder einem Leistungskriterium, das dem Kontinuum-Roboter zugeordnet ist und/oder einem Bereich eines Arbeitsraums, der von dem in der ersten Mehrzahl von Kandidatendesigns enthaltenen Kandidatendesign erreichbar ist und/oder einer Trajektorie innerhalb des Arbeitsraums, die von dem in der ersten Mehrzahl von Kandidatendesigns enthaltenen Kandidatendesign ausgeführt werden kann, basiert.

4. Computerimplementiertes Verfahren nach Anspruch 3, wobei das dem Kontinuum-Roboter (200) zugeordnete Zielkriterium eine Gesamtarmlänge und/oder einen Drehmomentfaktor und/oder ein Gesamtgewicht und/oder eine Anzahl von Kontinuum-Gelenken (210, 220, 230) enthält, die in dem Kontinuum-Roboter enthalten sind.

5. Computerimplementiertes Verfahren nach Anspruch 3 oder Anspruch 4, wobei das dem Kontinuum-Roboter (200) zugeordnete Leistungskriterium einen Erreichbarkeitsfaktor und/oder einen Trajektorienfaktor enthält.

6. Computerimplementiertes Verfahren nach Anspruch 5, wobei das Bestimmen des ersten Leistungswertes das Durchführen eines hybriden Ansatzes umfasst, der das Bestimmen der Erreichbarkeit für einen ersten Abschnitt des Bereichs des Arbeitsraums über Vorwärtskinematik und der Erreichbarkeit für einen zweiten Abschnitt des Bereichs des Arbeitsraums über inverse Kinematik enthält.

7. Computerimplementiertes Verfahren nach Anspruch 6, wobei das Erzeugen der ersten Mehrzahl von Kandidatendesigns das Berechnen von Werten für den ersten Satz von Werten umfasst, die mit der mindestens eine Designparameter-Beschränkung übereinstimmen.

8. Computerimplementiertes Verfahren nach Anspruch 6 oder Anspruch 7, wobei die mindestens eine Designparameter-Beschränkung eine maximale Anzahl von Kontinuum-Gelenken (210, 220, 230), die in dem Kontinuum-Roboter (200) enthalten sind und/oder eine minimale Anzahl von Kontinuum-Gelenken, die in dem Kontinuum-Roboter enthalten sind und/oder eine erforderliche Anzahl von Kontinuum-Gelenken, die in dem Kontinuum-Roboter enthalten sind und/oder eine maximale Gesamtarmlänge des Kontinuum-Roboters und/oder eine relative Position zwischen dem Kontinuum-Roboter und einem Arbeitsraum und/oder eine Form des Arbeitsraums enthält.

9. Computerimplementiertes Verfahren nach einem der Ansprüche 1-8, wobei das Erzeugen der ersten Mehrzahl von Kandidatendesigns das Berechnen des ersten Satzes von Werten für jedes Kandidatendesign, das in der ersten Mehrzahl von Kandidatendesigns enthalten ist, basierend auf einem globalen Optimierungsprozess umfasst.

10. Computerimplementiertes Verfahren nach Anspruch 9, wobei der globale Optimierungsprozess eine Zielfunktion enthält, die auf einer Mehrzahl von Zielkriterien basiert, die dem Kontinuum-Roboter (200) zugeordnet sind.

11. Computerlesbares Medium, das Anweisungen speichert, die, wenn sie von einem Prozessor ausgeführt werden, den Prozessor veranlassen, das Verfahren nach einem der Ansprüche 1-10 durchzuführen.

12. System, umfassend:
einen Speicher (1010), der Anweisungen speichert; und
einen Prozessor (1050), der kommunikativ mit dem Speicher gekoppelt ist und dazu konfiguriert ist, beim Ausführen der Anweisungen das Verfahren nach einem der Ansprüche 1-10 durchzuführen.

## Revendications

1. Procédé mis en œuvre par ordinateur pour générer une conception de robot continuum (200), le procédé comprenant :
la génération (902) d'une première pluralité de conceptions candidates (102) du robot continuum, dans lequel chaque conception candidate incluse dans la première pluralité de conceptions candidates est basée sur un premier ensemble de valeurs (101) d'un ensemble de paramètres de conception ;
la détermination (903) d'une première valeur de performance pour chaque conception candidate incluse dans la première pluralité de conceptions candidates ;
en fonction au moins en partie des premières valeurs de performance, la sélection (905) d'un sous-ensemble de conceptions candidates (104) parmi la première pluralité de conceptions candidates ; et
en fonction du sous-ensemble de conceptions candidates, la génération (902) d'une deuxième pluralité de conceptions candidates du robot continuum, dans lequel chaque conception candidate incluse dans la deuxième pluralité de conceptions candidates est basée sur un deuxième ensemble de valeurs de l'ensemble de paramètres de conception.

2. Procédé mis en œuvre par ordinateur selon la revendication 1, dans lequel l'ensemble de paramètres de conception comporte au moins un nombre d'articulations continuum (210, 220, 230) incluses dans une conception candidate, un rayon de courbure minimal de chaque articulation continuum incluse dans la conception candidate, une longueur d'une partie rigide associée à chaque articulation continuum incluse dans la conception candidate ou une longueur redressée de chaque articulation continuum incluse dans la conception candidate.

3. Procédé mis en œuvre par ordinateur selon la revendication 1 ou la revendication 2, dans lequel la première valeur de performance est basée sur au moins un critère d'objectif associé au robot continuum (200), un critère de performance associé au robot continuum, une région d'un espace de travail accessible par la conception candidate incluse dans la première pluralité de conceptions candidates, ou une trajectoire dans l'espace de travail pouvant être réalisée par la conception candidate incluse dans la première pluralité de conceptions candidates.

4. Procédé mis en œuvre par ordinateur selon la revendication 3, dans lequel le critère d'objectif associé au robot continuum (200) comprend au moins une longueur totale de bras, un facteur de couple, un poids total ou un nombre d'articulations continuum (210, 220, 230) incluses dans le robot continuum.

5. Procédé mis en œuvre par ordinateur selon la revendication 3 ou la revendication 4, dans lequel le critère de performance associé au robot continuum (200) comporte au moins un facteur d'accessibilité ou un facteur de trajectoire.

6. Procédé mis en œuvre par ordinateur selon la revendication 5, dans lequel la détermination de la première valeur de performance comprend la réalisation d'une approche hybride qui comporte la détermination d'une accessibilité à une première partie de la région de l'espace de travail par une cinématique directe et d'une accessibilité à une deuxième partie de la région de l'espace de travail par une cinématique inverse.

7. Procédé mis en œuvre par ordinateur selon la revendication 6, dans lequel la génération de la première pluralité de conceptions candidates comprend le calcul de valeurs du premier ensemble de valeurs conformes à l'au moins une contrainte de paramètre de conception.

8. Procédé mis en œuvre par ordinateur selon la revendication 6 ou la revendication 7, dans lequel l'au moins une contrainte de paramètre de conception comporte au moins un nombre maximum d'articulations continuum (210, 220, 230) incluses dans le robot continuum (200), un nombre minimum d'articulations continuum incluses dans le robot continuum, un nombre requis d'articulations continuum incluses dans le robot continuum, une longueur de bras totale maximale du robot continuum, une position relative entre le robot continuum et un espace de travail, ou une forme de l'espace de travail.

9. Procédé mis en œuvre par ordinateur selon l'une quelconque des revendications 1 à 8, dans lequel la génération de la première pluralité de conceptions candidates comprend le calcul, pour chaque conception candidate incluse dans la première pluralité de conceptions candidates, du premier ensemble de valeurs suivant un processus d'optimisation globale.

10. Procédé mis en œuvre par ordinateur selon la revendication 9, dans lequel l'optimisation globale comporte une fonction objective basée sur une pluralité de critères d'objectif associés au robot continuum (200).

11. Support lisible par ordinateur stockant des instructions qui, à leur exécution par un processeur, amènent le processeur à réaliser le procédé selon l'une des revendications 1 à 10.

12. Système comprenant :
une mémoire (1010) qui stocke des instructions ; et
un processeur (1050) couplé de manière communicative à la mémoire et configuré pour, lors de l'exécution des instructions, réaliser le procédé selon l'une quelconque des revendications 1 à 10.
